# EUROPEAN PATENT SPECIFICATION

(11) **EP 3 504 789 B1**
(45) Date of publication and mention of the grant of the patent: **02.10.2024**
(21) Application number: 17777955.0
(22) Date of filing: 23.08.2017
(51) Int. Cl.: H02P 29/024

(54) **SYSTEM FOR MONITORING CONDITION OF A PLURALITY OF MOTORS**
SYSTEM ZUR ÜBERWACHUNG DES ZUSTANDS EINER VIELZAHL VON MOTOREN
SYSTÈME DE SURVEILLANCE DE L'ÉTAT D'UNE PLURALITÉ DE MOTEURS

(30) Priority: 23.08.2016 CN 201610705701
(43) Date of publication of application: 03.07.2019
(73) Proprietor: ABB Schweiz AG, 5400 Baden (CH)
(72) Inventor: KRISHNAMOORTHI, Karthik, Chennai Tamil Nadu 600061 (IN); PINTO, Cajetan, Mumbai 400500 (IN); ORMAN, Maciej, Shanghai 201319 (CN); URALA, Anant, Mumbai 400071 (IN); HEQUING SUN, Amandine, Shanghai 200001 (CN); RZESZUCINSKI, Pawel, 47-200 Kedzierzyn-Kozle (PL)
(74) Representative: Zimmermann & Partner Patentanwälte mbB
(86) International application number: PCT/IB2017/055071
(87) International publication number: WO 2018/037348

(56) References cited:
- WO-A1-2015/173662
- WO-A1-2016/037711
- WO-A2-2008/116966
- US-A1- 2011 161 402
- US-A1- 2013 030 765
- US-A1- 2013 211 546
- US-A1- 2016 041 068
- ABB: "ABB's smart sensor (English version)", 29 April 2016 (2016-04-29), XP055798225, Retrieved from the Internet <URL:https://www.youtube.com/watch?v=Q7Q6OfPkCpM> [retrieved on 20210422]
- KENNEDY SHEILA: "Condition monitoring in the cloud (Part 1)", 9 June 2015 (2015-06-09), XP055797375, Retrieved from the Internet <URL:http://www.plantservices.com/articles/2015/technology-toolbox-condition-monitoring-cloud/> [retrieved on 20210420]
- ITT: "i-Alert Condition Monitor Installation, Operation, and Maintenance Manual", 30 April 2010 (2010-04-30), XP055797386, Retrieved from the Internet <URL:https://www.gouldspumps.com/ittgp/medialibrary/goulds/website/Literature/Instruction%20and%20Operation%20Manuals/Alphabetical/InstallationOperationMaintenance_iALERT.pdf?ext=.pdf> [retrieved on 20210420]
- CIUFO CHRIS A.: "Mentor Graphics Connects IoT Devices, Gateway to Cloud", 22 March 2016 (2016-03-22), XP055797378, Retrieved from the Internet <URL:http://eecatalog.com/> [retrieved on 20210420]
- ABB: "ABB's smart sensor", 29 April 2016 (2016-04-29), XP055797972, Retrieved from the Internet <URL:https://www.youtube.com/watch?v=Q7Q6OfPkCpM> [retrieved on 20210422]
- ANAND VIJAY: "Remote condition monitoring of motors using the power of the Internet", 9 September 2015 (2015-09-09), XP055797377, Retrieved from the Internet <URL:https://www.je-bearing.com/news/remote-condition-monitoring-motors-using-power-internet/> [retrieved on 20210420]
- ABB: "Condition Monitoring WiMon 100 wireless vibration and temperature sensor", 20 December 2018 (2018-12-20), XP055797394, Retrieved from the Internet <URL:https://search.abb.com/library/Download.aspx?DocumentID=9AKK106930A7682&LanguageCode=en&DocumentPartId=&Action=Launch> [retrieved on 20210420]
- ABB: "Condition Monitoring Wireless vibration monitoring system", 20 December 2018 (2018-12-20), XP055797393, Retrieved from the Internet <URL:https://new.abb.com/oil-and-gas> [retrieved on 20210420]
- BERTHEAU TOM: "ABB's new condition monitoring solution is quantum leap for millions of motors", 21 January 2016 (2016-01-21), XP055798210, Retrieved from the Internet <URL:https://global.abb/group/en>
- VAVRA BOB ET AL: "Condition monitoring system for voltage, current, temperature", 21 July 2016 (2016-07-21), XP055797385, Retrieved from the Internet <URL:https://www.controleng.com/articles/condition-monitoring-system-for-voltage-current-temperature/> [retrieved on 20210420]
- ABB: "ABB's new condition monitoring solution is quantum leap for millions of motors", 21 January 2016 (2016-01-21), XP055797966, Retrieved from the Internet <URL:https://global.abb/group/en/media> [retrieved on 20210422]
- KENNEDY SHEILA: "Condition monitoring in the cloud (Part 2)", 1 December 2015 (2015-12-01), XP055797381, Retrieved from the Internet <URL:https://www.plantservices.com/home/article/11307822/condition-monitoring-in-the-cloud-part-2> [retrieved on 20210420]
- CULHAM TRAVIS: "Wireless Vibration Monitoring - improves reliability and enhances safety", 30 April 2013 (2013-04-30), XP055797392, Retrieved from the Internet <URL:https://www.emersonautomationexperts.com/2013/asset-management/applying-wireless-vibration-monitoring-in-electrical-power-stations/> [retrieved on 20210420]

## Description

### TECHNICAL FIELD

The current invention relates to the field of condition monitoring of electric machines, and more particularly, the current invention relates to a system for detection and determination of faults on a fleet of motors.

### BACKGROUND ART

Conventionally, assessment of status and detection of faults in a motor is done using a plurality of diagnostic devices and techniques have been developed so far. Among them, the most widely used in industry are vibration monitoring and current signature analysis.

The above mentioned methods rely on measurement of motor current and vibration for detecting faults in the motor. These methods have traditionally been done based on a point-based approach for vibration and electrical analysis is carried out by measuring current and/or voltage from a separate location. This approach has been too expensive to adopt to low-value assets in factories, leaving large numbers of LV motors without any health information.

Additionally, for carrying out measurements, these methods often require sensors and other equipment which are often cumbersome to install, and are expensive. Moreover, the current and voltage sensors have to be installed inside terminal box of the motor, which is often time consuming and requires the motor to be shut down. Further, improper installation of sensors can result in damage to the motor, faulty monitoring or can cause safety concerns. US 2013/0211546 A1 describes a smart device for industrial automation. WO 2015/173662 A1 describes a method and system for detecting rotor fault. WO 2008/116966 A2 describes a method and apparatus for monitoring condition of electric machines. WO 2016/037711 A1 describes a system for monitoring operation status of electric machine and mobile phone therefore and a server-based system using the same. US 2016/041068 A1 discloses collection and analysis of machine diagnostic data using fixed condition monitoring devices for collecting vibration data, a mobile device able to configure the fixed devices, and a server.

Therefore, in light of the above discussion, there is a need for system for monitoring a plurality of motors that solves the problems mentioned above.

### SUMMARY

The invention is defined by the independent claim. The dependent claims define further embodiments of the invention. The present invention discloses a system for monitoring condition of a plurality of motors. The system comprises a plurality of condition monitoring devices for measuring one or more parameters associated with the corresponding motors, a gateway device (also referred to as gateway) communicatively coupled to the plurality of condition monitoring devices over a first wireless communication network, for communicating measurement data from the condition monitoring devices, a server configured to receive measurement data from the gateway device and to detect a condition of at least one motor from the plurality of motors. Each condition monitoring device is mounted on the body of the corresponding motor. The one or more measured parameters include leakage magnetic flux in a first axis and leakage magnetic flux in a second axis.

In an embodiment, the server includes one or more equipment models corresponding to the one or more motors wherein each equipment model is updated based on the measurement data from a corresponding condition monitoring device associated with corresponding motor.

In another embodiment, the gateway is configured to determine one or more operating parameters for at least one condition monitoring device from the plurality of condition monitoring devices, based on coordination with the server and at least one of controller associated with process equipment connected to the corresponding motor and drive connected to the corresponding motor. In another embodiment, the gateway device includes one or more sensors for measuring ambient physical parameters. The gateway then sends the data based on the measurement of the ambient physical parameters to the server, which is used by the server for analysis of motor including aging analysis. In the invention the system also includes a mobile device for configuring the condition monitoring devices along with the gateway and for displaying one or more alert messages associated with the detected condition of the at least one motor based on a message from the server. The mobile device includes a plurality of sensors for measuring a second set of measurement values of a plurality of parameters of a corresponding motor, the second set of measurement values being in relation to vibration and magnetic field; and a processor for determining one or more operating parameters for a corresponding condition monitoring device affixed to the corresponding motor, based on the second set of measured values of the plurality of parameters of the corresponding motor.

### BRIEF DESCRIPTION OF THE DRAWINGS

The subject matter of the invention will be explained in more detail in the following text with reference to preferred exemplary embodiments which are illustrated in the drawings, in which:
Figure 1 illustrates system for monitoring condition of a fleet of motors, in accordance with first embodiments of the present invention; and
Figure 2 illustrates system for monitoring condition of a fleet of motors, in accordance with second embodiments of the present invention.

### DETAILED DESCRIPTION

In the following detailed description, reference is made to the accompanying drawings that form a part hereof, and in which is shown by way of illustration specific embodiments, which may be practiced. These embodiments are described in sufficient detail to enable those skilled in the art to practice the embodiments.

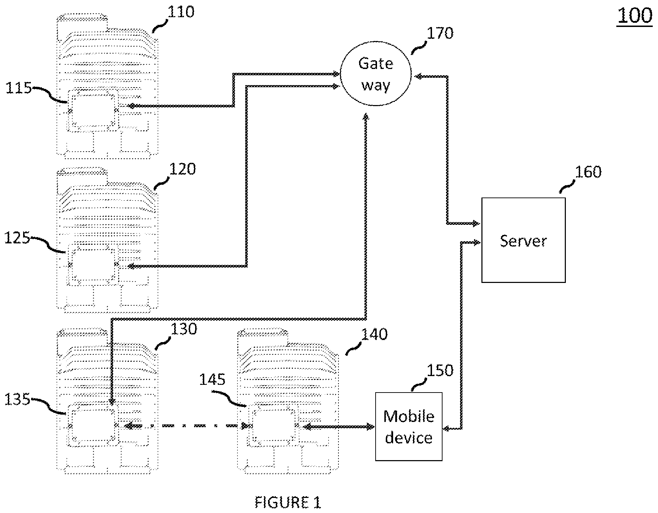

Figure 1 illustrates a system 100 for monitoring condition of a plurality of motors (110, 120, 130 and 140). The system 100 includes a plurality of condition monitoring devices (115, 125 135, and 145), installed on the plurality of corresponding motors (110, 120, 130 and 140), for measuring one or more parameters associated with the corresponding motors (110, 120, 130 and 140) in a non-invasive manner.

In an embodiment, each condition monitoring device is a fixed device which acquires the measurement signals periodically and processes it to acquire the operating and health conditions of the motor in accordance with an operating configuration. Each condition monitoring device also has memory on board on which the operating configuration is stored. Each condition monitoring device comprises a housing body capable of being affixed to a body of the motor, a plurality of sensors and a communication module for transmitting the measurements, housed in the housing body. In an embodiment, the condition monitoring device is mounted on the surface of a motor close to the drive side in order to monitor the bearing, the rotor and the operating conditions of the motor.

The sensors include at least one magnetic field measuring unit, at least one vibration sensor, an acoustic sensor and a temperature sensor. The magnetic field measuring unit measures a first value of magnetic field strength along a first axis substantially parallel to the axis of the rotor of the electric machine and a second value of magnetic field strength along a second axis. The second axis is at an angle to the first axis. The vibration sensor measures at least one of a first value of vibration along the first axis and a second value of vibration along the second axis. The temperature sensor measures a temperature of an area proximal to the electrical machine and an acoustic sensor, for measuring sound around the electrical machine. Accordingly, the one or more parameters include leakage magnetic flux in a first axis and leakage magnetic flux in a second axis, vibration along one or more axes, sound about the motor and temperature about the motor. In an embodiment, each condition monitoring device includes one or more processors configured to receive measurements from the plurality of sensors, and to determine health of the corresponding motor based on the received measurements.

Operating configuration of a condition monitoring device comprises a plurality of operational parameters (and their values) relating to measurement and diagnostic operations performed by the condition monitoring device and can include parameters such as detection or threshold parameters or alarm values, measurement related parameters such as sampling rates, parameters related to baselining of sensor values, machine construction parameters (stator slots, rotor bars, gear teeth, pump blades), duty cycle rate of the condition monitoring device, etc.

The processors of the condition monitoring device utilize the operating configuration i.e. the values of operational parameters for operating the sensors and for performing diagnostics. For example, based on the value of the sensor sampling rate operational parameter, the processors operate the sensors at the defined intervals as per the value of the sensor sampling rate operational parameter for measuring the electrical and mechanical parameters of the corresponding motor. Similarly, the processors utilize the values of operational parameters related to diagnostics in determining the condition of the corresponding motor. For example, when the unbalance in the magnetic field is above value associated threshold parameter for unbalance, then a fault is detected and determined by the processors.

The condition monitoring devices (115, 125 135 and 145) are communicatively coupled to a gateway device 170. The communication module of each condition monitoring device can be configured to communicate with the gateway device 170 over a first communication network. In an embodiment the first communication network is based on a wireless protocol such as Bluetooth, WIFI, Zigbee, LoRAWan etc. In an embodiment, the condition monitoring devices communicate their measurement data and data related to the health of the corresponding motor to the gateway device 170. The gateway device 170 then transmits the measurement data and data related to the health of the corresponding motor to a server 160. The server 160 utilizes the received data for performing asset analysis of the motors including health, condition and aging estimation of the motors.

In an embodiment, the condition monitoring devices (115, 125 135 and 145) are capable of connecting to each other over a short range communication network. For example, in case a condition monitoring device 145 is unable to connect to the gateway 170, then the condition monitoring device 145 can connect to the neighboring condition monitoring device 135 for transmitting data to gateway 170 via the neighboring condition monitoring device 135.

In an embodiment, the server 160 includes plurality of equipment models corresponding to the plurality of motors (110, 120, 130 and 140). Each equipment model of a particular motor is updated based on the data based on measurements of the parameters of the corresponding motor from the corresponding condition monitoring device mounted on the corresponding motor. The updated equipment model associated with the motor is utilized by the server in performing asset analytics of the motor by the server. In an embodiment, the server 160 is for analyzing the measurements from the condition monitoring devices, and store the same in an archive. The server 160 includes a plurality of algorithms for processing the measurements. The server 160 additionally includes a communication interface for informing users associated with the motor about the motor health using SMS or email, or the like.

In an embodiment, the gateway device 170 is also equipped with one or more sensors for measuring ambient environmental parameters such as temperature, noise level, background magnetic fields, etc. The measured values of the ambient environment parameters are communicated by the gateway to the condition monitoring devices (115, 125, 135 and 145) and the server 170 for use along with the measurements from the condition monitoring devices for determining the condition of the motors.

The system 100 further comprises a mobile device 150 associated with a field personnel, for configuring at least one condition monitoring device from the condition monitoring devices (115, 125, 135, 145), and for displaying one or more alert messages associated with the detected condition of the at least one motor. In an embodiment, the condition monitoring devices are triggered to start taking measurements upon receiving a signal from the mobile phone 150 and/or the gateway device 170. Measurements of the parameters of the corresponding motor is stored on local memory of the sensing block of the condition monitoring device after which the measurements are transferred to the server via the mobile phone 150 or the gateway device 170.

In an embodiment, the mobile phone 150 and the gateway 170 are capable of preprocessing the measurements from the condition monitoring devices including performing a data quality check (proper measurement condition verification). The data is stored temporarily in the memory of the mobile phone 150 or the gateway 150 and is then transferred to the server 160.

It is to be noted by a person skilled in the art while the gateway 170 and the server 160 are shown and described as individual devices, the functionality of the gateway 170 and the server 160 may be performed via one or more devices in coordination and can be realized by dedicated hardware or software components.

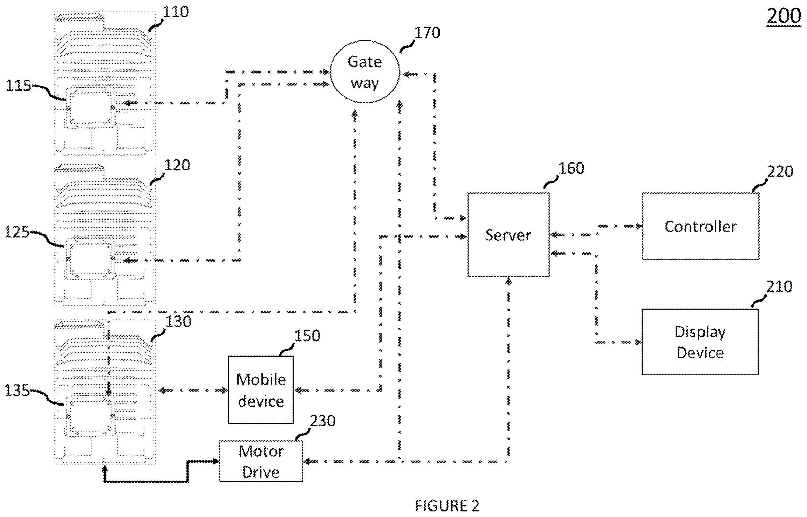

The operating configuration of one or more condition monitoring devices from the plurality of condition monitoring devices is configured by the gateway device 170 and the mobile device 150. This is further explained in reference to figure 2.

Figure 2 illustrates another view 200 of the system 100 for monitoring condition of the fleet of motors (110, 120, 130), in accordance with second embodiment of the present invention. The system resides in a plant having a plurality of industrial processes and process equipment operated by controllers. One or more motors are operated using motor drives in the plant. In addition to the previously mentioned components of the system 100, additionally a controller 220, a motor drive 230 and a display device 210 are shown. The motor drive 230 is operatively coupled to the motor 135 for operating the motor 130. The motor drive 230 is communicatively coupled to the gateway 170 and the server 160. Similarly the controller 220 is connected to a process equipment such as a boiler which is fed by a pump driven by motor 120. The controller 220 is communicatively coupled to the server 160. The display device 210 is used by the field personnel for visualizing the condition of the fleet of the motors based on the conditions of the motors determined by the server 160.

The gateway device 170 configures the operating configuration of one or more condition monitoring devices based on coordination with the server. In an embodiment, the operating configuration i.e. the operating parameters for each condition monitoring device is set to predetermined values available with the server 160. The server 160 provides the operating configuration with the predetermined values for the operating parameters to the gateway device 170 and accordingly the gateway device 170 then configures the operating configuration in the memory of each condition monitoring device using the predetermined values received from the server 160.

In another embodiment based on inputs associated with the process equipment and motors, the gateway 170 and server 160 can modify the values of the operating parameters for one or more particular condition monitoring device. This is further explained below.

For example, based on the on inputs from the motor drive 230, the server 160 determines the values of the operating parameters for the operating configuration of the condition monitoring device 135 attached to the motor 130. The gateway 170 accordingly configures the condition monitoring device 135 based on the determined values from the server 160. For example, when the motor 130 is to be operated at full speed by the drive 230, this information is provided by the motor drive 230 to the server 160. The server 160 accordingly determines that value of the sampling rate of the vibration sensor of the condition monitoring device 135, is to be increased by ten percentage of the preset value. Accordingly, the gateway 170, in coordination with the server 160, changes the operating configuration of the condition monitoring device 135 to ensure increased sampling of vibration. Similarly, when the motor drive 230 provides input to the server 160 that the motor 130 will be deenergised for few hours, the server 160 accordingly determines that the duty cycle rate of the condition monitoring device 135 is to be increased. Accordingly, the server 160 along with the gateway 170 changes the operating parameter value of the duty cycling rate to preserve energy of the condition monitoring device 135.

Similarly, in an embodiment, based on the input from the controller 220, the server 160 determines the operating configuration for the condition monitoring device 125 and the gateway 170 device in coordination with the server 160, configures (or changes/updates) the operating configuration of the condition monitoring device 125. The controller 220 accordingly provides input i.e. information regarding the pump driven by the motor 125 to the server 160 and accordingly the server 160 determines values of the operational parameter based on the information of the pump. For example, when the pump is driven to the motor 125, the gateway 170 based on the server's determination, reduces, changes, reconfigures or sets the value of the overload threshold parameter to 80% of rated load from 120% of rated load (which is the preset value) in the operating configuration in the memory of the condition monitoring device 125.

Similarly, in an embodiment, based on the input from the ERP system, the server 160 determines the operating configuration for the condition monitoring device 125 and the gateway device 170 in coordination with the server 160, configures (or changes/updates) the operating configuration of the condition monitoring device 125. For example, based on the input regarding the maintenance strategy associated with the motor 120, the server 160 determines the operating configuration for the condition monitoring device 125, which is then utilized by the gateway 170 to configure the condition monitoring device 125. For example, when the motor 120 has critical importance in the plant, the maintenance strategy would be to reduce down time, accordingly the operating configuration of the condition monitoring device 125 is set to take frequent measurements with lower threshold values by the gateway device 170.

The mobile device 150 includes a plurality of sensors for measuring a second set of measurement values of a plurality of parameters of a corresponding motor, and a processor for determining one or more operating parameters for a corresponding condition monitoring device affixed to the corresponding motor, based on the second set of measurement values of the plurality of parameters of the corresponding motor. Using second set of measurement values, particularly in relation to vibration (frequency spectrum and presence of side bands) and magnetic field, the mobile device 150 can detect a precondition indicative of an external misalignment fault. Accordingly, the mobile device 150 can determine that the motor 110 is more prone to bearing problems due to the presence of the external misalignment fault. Accordingly, the mobile device 150 via the gateway 170 changes the operating configuration of the condition monitoring device 115. The gateway 170 sets a value of the threshold parameter for the bearing fault parameter (which is lower that the value of the threshold parameter for the bearing fault parameter for an average electric machine) as there is a possibility of accelerated bearing failure due to the external misalignment fault. Accordingly, by setting an appropriately low value associated with threshold parameter for bearing fault, the condition monitoring device 115 can identify a bearing fault (caused by the external misalignment) and thereby appropriate maintenance can be scheduled and unscheduled down time can be avoided.

Similarly, values of operational parameters associated with measurement can also be set or changed. In a second example, based on the second set of measurement values, the mobile device 150 determines a precondition associated with a fault which is primarily mechanical in nature and not associated with the electrical parameters of the motor 110. Accordingly, based on this determination information or input from the mobile device, the gateway 170 sets a value (higher than the preset value of sampling rate of vibration for an average electric machine) associated with measurement parameter sampling frequency or sampling rate of vibration in the condition monitoring device 115, and sets a value ( lower than the preset value) associated with measurement parameter the sampling frequency of magnetic flux, so that the processors of the condition monitoring device 115 can operate the magnetic field sensor and the vibration sensor optimally, to utilize power in lieu of the electric machine's precondition associated with mechanical faults.

In an embodiment, the mobile phone 150 is programmed for automatic or manual commissioning the condition monitoring device. In an embodiment, the mobile device 150 further includes a tag reader for reading a smart name plate associated with the motor and a GPS tracker in an embodiment, a plurality of NFC or similar data tags are attached to the motor body. The mobile device is configured to read these tags and use the information on the tags to configure the condition monitoring device via the gateway device 170.

In an embodiment, at least one condition monitoring device includes one or more portable sensors capable of being moved around the motor, and fixed sensors attached to the shell of the motor. In another embodiment, each sensor from the plurality of sensors of at least one condition monitoring device is capable of being mounted on distinct (or different) locations on the corresponding motor and are configured to operate simultaneously to provide measurements.

. The mobile device 150 includes a diagnostic application for processing the measurements in co-ordination with the sensor and for presenting the information associated with the motor on a user interface of the application. In an embodiment, the application includes role and user based access control.

Accordingly, the present disclosure describes a system for monitoring condition of a plurality of motors having configurable condition monitoring devices configured via the gateway device to accommodate process equipment or motor related inputs. Additionally, the ability to measure data from a plurality of points around the motors and in the environment of the motors is leveraged for configuring the parameters of the condition monitoring devices for ensuring faster and optimized detection by modifying measurement and detection parameters in the condition monitoring device.

This written description uses examples to describe the subject matter herein, including the best mode, and also to enable any person skilled in the art to make and use the subject matter. The patentable scope of the subject matter is defined by the appended claims.

## Claims

1. A system (100) for monitoring condition of a plurality of motors (110, 120, 130, 140) in a plant comprising a plurality of process equipment operatively connected to one or more controllers, the system (100) comprising:
a. a plurality of condition monitoring devices (115, 125, 135, 145), wherein each condition monitoring device is mounted on the body of a motor from the plurality of motors, wherein each condition monitoring device is for measuring a first set of one or more parameters of the corresponding motor (110, 120, 130, 140) in accordance with an operating configuration;
b. a gateway device (170) communicatively coupled to the plurality of condition monitoring devices (115, 125, 135, 145) over a first communication network, for communicating measurement data from the condition monitoring devices (115, 125, 135, 145); and
c. a server (160) configured to receive data based on measurements of the parameters of the motors from the condition monitoring devices, via the gateway device (170), and to detect a condition of at least one motor from the plurality of motors (110, 120, 130, 140); and wherein the system further includes at least one mobile device (150), adapted to configure at least one condition monitoring device from the condition monitoring devices (115, 125, 135, 145), and to display one or more alert messages associated with the detected condition of the at least one motor based on a message from the server (160), and wherein the at least one mobile device (150) includes
i) a plurality of sensors for measuring a second set of measurement values of a plurality of parameters of the corresponding motor, the second set of measurement values being in relation to vibration and magnetic field;
ii) a processor for determining one or more operating parameters for a corresponding condition monitoring device affixed to the corresponding motor, based on the second set of measurement values of the plurality of parameters of the corresponding motor.

2. The system as claimed in claim 1, wherein the gateway device (170) determines operating
configuration of at least one condition monitoring device from the plurality of condition monitoring devices (115, 125, 135), based on coordination with the server (160), wherein
the operating configuration includes a plurality of operational parameters associated with measurement and diagnostics performed by the at least one condition monitoring device.

3. The system (100) as claimed in claim 1, wherein the server (160) includes plurality of equipment models corresponding to the plurality of motors (110, 120, 130, 140) wherein each equipment model is updated based on the data based on measurements of the parameters of the corresponding motor from the corresponding condition monitoring device mounted on the corresponding motor and wherein the server is configured to detect the condition of a motor based on the data based on measurements of the parameters of the motors and the updated equipment model associated with the motor.

4. The system (100) as claimed in claim 1, wherein the one or more parameters includes one of leakage magnetic flux in a first axis, leakage magnetic flux in a second axis, vibration along the first axis and the second axis, and a temperature of an area proximal to the corresponding motor.

5. The system (100) as claimed in claim 1, wherein the gateway device (170) includes one or more sensors for measuring ambient physical parameters and for communicating the data based on the measurement of the ambient physical parameters to the server (160).

6. The system (100) as claimed in claim 2, wherein the plurality of operational parameters of the at least one condition monitoring device includes at least a threshold value associated with a fault condition.

## Patentansprüche

1. System (100) zum Überwachen des Zustands einer Vielzahl von Motoren (110, 120, 130, 140) in einer Anlage, die eine Vielzahl von Prozessausrüstungen umfasst, die mit einer oder mehreren Steuervorrichtungen wirkverbunden sind, wobei das System (100) umfasst:
a. eine Vielzahl von Zustandsüberwachungsvorrichtungen (115, 125, 135, 145), wobei jede Zustandsüberwachungsvorrichtung an dem Gehäuse eines Motors aus der Vielzahl von Motoren angebracht ist, wobei jede Zustandsüberwachungsvorrichtung zum Messen eines ersten Satzes eines oder mehrerer Parameter des entsprechenden Motors (110, 120, 130, 140) gemäß einer Betriebskonfiguration dient;
b. eine Gateway-Vorrichtung (170), die über ein erstes Kommunikationsnetzwerk mit der Vielzahl von Zustandsüberwachungsvorrichtungen (115, 125, 135, 145) kommunikationsfähig zum Übermitteln von Messdaten aus den Zustandsüberwachungsvorrichtungen (115, 125, 135, 145) gekoppelt ist; und
c. einen Server (160), der dazu ausgelegt ist, Daten basierend auf Messungen der Parameter der Motoren aus den Zustandsüberwachungsvorrichtungen über die Gateway-Vorrichtung (170) zu empfangen und einen Zustand mindestens eines Motors aus der Vielzahl von Motoren (110, 120, 130, 140) zu detektieren;
und wobei das System ferner mindestens eine Mobilvorrichtung (150) aufweist, die dazu angepasst ist, mindestens eine Zustandsüberwachungsvorrichtung aus den Zustandsüberwachungsvorrichtungen (115, 125, 135, 145) zu konfigurieren und eine oder mehrere Warnmeldungen im Zusammenhang mit dem detektierten Zustand des mindestens einen Motors basierend auf einer Nachricht aus dem Server (160) anzuzeigen,
und wobei die mindestens eine Mobilvorrichtung (150) Folgendes aufweist:
i) eine Vielzahl von Sensoren zum Messen eines zweiten Satzes von Messwerten einer Vielzahl von Parametern des entsprechenden Motors, wobei sich der zweite Satz von Messwerten auf Vibrationen und ein Magnetfeld bezieht;
ii) einen Prozessor zum Bestimmen eines oder mehrerer Betriebsparameter für eine entsprechende Zustandsüberwachungsvorrichtung, die an dem entsprechenden Motor befestigt ist, basierend auf dem zweiten Satz von Messwerten der Vielzahl von Parametern des entsprechenden Motors.

2. System nach Anspruch 1, wobei die Gateway-Vorrichtung (170) die Betriebskonfiguration mindestens einer Zustandsüberwachungsvorrichtung aus der Vielzahl von Zustandsüberwachungsvorrichtungen (115, 125, 135) basierend auf Koordination mit dem Server (160) bestimmt, wobei die Betriebskonfiguration eine Vielzahl von Betriebsparametern im Zusammenhang mit Messungen und Diagnosen enthält, die durch die mindestens eine Zustandsüberwachungsvorrichtung durchgeführt werden.

3. System (100) nach Anspruch 1, wobei der Server (160) eine Vielzahl von Ausrüstungsmodellen entsprechend der Vielzahl von Motoren (110, 120, 130, 140) umfasst, wobei jedes Ausrüstungsmodell basierend auf den Daten basierend auf Messungen der Parameter des entsprechenden Motors aus der entsprechenden, an dem entsprechenden Motor angebrachten Zustandsüberwachungsvorrichtung aktualisiert wird und wobei der Server dazu ausgelegt ist, den Zustand eines Motors basierend auf den Daten basierend auf Messungen der Parameter der Motoren und dem aktualisierten, dem Motor zugeordneten Ausrüstungsmodell zu erkennen.

4. System (100) nach Anspruch 1, wobei der eine oder die mehreren Parameter eines von magnetischem Streufluss in einer ersten Achse, magnetischem Streufluss in einer zweiten Achse, Vibration entlang der ersten Achse und der zweiten Achse und einer Temperatur eines Bereichs nahe dem entsprechenden Motor beinhalten.

5. System (100) nach Anspruch 1, wobei die Gateway-Vorrichtung (170) einen oder mehrere Sensoren zum Messen physikalischer Umgebungsparameter und zum Übermitteln der auf der Messung der physikalischen Umgebungsparameter basierenden Daten an den Server (160) enthält.

6. System (100) nach Anspruch 2, wobei die Vielzahl von Betriebsparametern der mindestens einen Zustandsüberwachungsvorrichtung mindestens einen mit einem Fehlerzustand zusammenhängenden Schwellenwert enthält.

## Revendications

1. Système (100) de surveillance de l'état d'une pluralité de moteurs (110, 120, 130, 140) dans une usine comportant une pluralité d'équipements de transformation reliés fonctionnellement à un ou plusieurs moyens de commande, le système (100) comportant :
a. une pluralité de dispositifs (115, 125, 135, 145) de surveillance d'état, chaque dispositif de surveillance d'état étant monté sur le corps d'un moteur parmi la pluralité de moteurs, chaque dispositif de surveillance d'état servant à mesurer un premier ensemble d'un ou plusieurs paramètres du moteur (110, 120, 130, 140) correspondant en fonction d'une configuration d'exploitation ;
b. un dispositif (170) de passerelle couplé de façon à pouvoir communiquer avec la pluralité de dispositifs (115, 125, 135, 145) de surveillance d'état via un premier réseau de communication, pour communiquer des données de mesures provenant des dispositifs (115, 125, 135, 145) de surveillance d'état ; et
c. un serveur (160) configuré pour recevoir des données basées sur des mesures des paramètres des moteurs en provenance des dispositifs de surveillance d'état, par l'intermédiaire du dispositif (170) de passerelle, et pour détecter un état d'au moins un moteur parmi la pluralité de moteurs (110, 120, 130, 140) ;
et le système comprenant en outre au moins un dispositif mobile (150), prévu pour configurer au moins un dispositif de surveillance d'état parmi les dispositifs (115, 125, 135, 145) de surveillance d'état, et pour afficher un ou plusieurs messages d'alerte associés à l'état détecté du ou des moteurs d'après un message provenant du serveur (160),
et le ou les dispositifs mobiles (150) comprenant
i) une pluralité de capteurs servant à mesurer un second ensemble de valeurs de mesures d'une pluralité de paramètres du moteur correspondant, le second ensemble de valeurs de mesures étant en relation avec des vibrations et un champ magnétique ;
ii) un processeur servant à déterminer un ou plusieurs paramètres d'exploitation relatifs à un dispositif correspondant de surveillance d'état fixé au moteur correspondant, d'après le second ensemble de valeurs de mesures de la pluralité de paramètres du moteur correspondant.

2. Système selon la revendication 1, le dispositif (170) de passerelle déterminant la configuration d'exploitation d'au moins un dispositif de surveillance d'état parmi la pluralité de dispositifs de surveillance d'état (115, 125, 135), sur la base d'une coordination avec le serveur (160), la configuration d'exploitation comprenant une pluralité de paramètres opérationnels associés à une mesure et à des diagnostics réalisés par le ou les dispositifs de surveillance d'état.

3. Système (100) selon la revendication 1, le serveur (160) comprenant une pluralité de modèles d'équipement correspondant à la pluralité de moteurs (110, 120, 130, 140) chaque modèle d'équipement étant mis à jour d'après les données basées sur des mesures des paramètres du moteur correspondant provenant du dispositif correspondant de surveillance d'état monté sur le moteur correspondant et le serveur étant configuré pour détecter l'état d'un moteur d'après les données basées sur des mesures des paramètres des moteurs et le modèle d'équipement mis à jour associé au moteur.

4. Système (100) selon la revendication 1, le ou les paramètres comprenant un paramètre parmi un flux magnétique de fuites suivant un premier axe, un flux magnétique de fuites suivant un second axe, des vibrations suivant le premier axe et le second axe, et une température d'une zone proche du moteur correspondant.

5. Système (100) selon la revendication 1, le dispositif (170) de passerelle comprenant un ou plusieurs capteurs servant à mesurer des paramètres physiques ambiants et à communiquer au serveur (160) les données basées sur la mesure des paramètres physiques ambiants.

6. Système (100) selon la revendication 2, la pluralité de paramètres opérationnels du ou des dispositifs de surveillance d'état comprenant au moins une valeur seuil associée à un état de défaillance.
